# EUROPEAN PATENT APPLICATION

(11) **EP 2 339 648 A1**
(43) Date of publication of application: **29.06.2011**
(21) Application number: 09180580.4
(22) Date of filing: 23.12.2009
(51) Int. Cl.: H01L 31/18, H01L 31/0216

(54) **Enhanced passivation layer for wafer based solar cells, method and system for manufacturing thereof**

(71) Applicant: Applied Materials, Inc., Santa Clara, CA 95054 (US)
(72) Inventor: Dieter, Torsten Bruno, 63628 Bad Soden Salmuenster (DE); Trassl, Roland, 35392 Giessen (DE); Goergens, Carsten, 01129 Dresden (DE)
(74) Representative: Zimmermann & Partner

(57) **Abstract**

A solar cell module layer stack is described. The layer stack includes a doped silicon wafer substrate (101), a further layer (102) of the substrate or deposited on the substrate, wherein the further layer is doped for generation of a p-n-junction with the doped silicon wafer substrate; and a first sputtered passivation layer (112, 114) deposited on the doped silicon wafer substrate (101) or the further layer (102), wherein the passivation layer is selected from the group consisting of: an aluminum-containing oxide layer, an aluminum-containing oxynitride layer, and mixtures thereof; and wherein the passivation layer being plasma treated under a hydrogen-containing atmosphere and/or wherein the layer stack further comprises a hydrogen-containing cap layer (202) on the passivation layer.

## Description

### TECHNICAL FIELD OF THE INVENTION

Embodiments of the present invention relate to passivation of wafer based solar cells. Particularly, they relate to reactively-sputtered, hydrogen-treated, aluminum-containing passivation layers and methods of depositing same. Specifically, they relate to a solar cell layer stack, a method of manufacturing a solar cell layer stack, and a system for depositing a solar cell layer stack.

### BACKGROUND OF THE INVENTION

Photovoltaic (PV) cells or solar cells are material junction devices which convert sunlight into direct current (DC) electrical power. When exposed to sunlight, i.e., photons, the electric field of solar cell p-n junctions separates pairs of electrons and holes, thus generating a photo-voltage. A circuit from n-side to p-side allows the flow of electrons when the solar cell is connected to an electrical load, while the area and other parameters of the PV cell junction device determine the available current.

Solar cells have evolved significantly over the past two decades, with experimental efficiencies increasing from less than about 5% in 1980 to almost 40% in 2008. The most common solar cell material is silicon, which is used, for example, in the form of single or polycrystalline wafers. Because the amortized cost of forming silicon-based solar cells to generate electricity is higher than the cost of generating electricity using traditional methods, there has been an effort to reduce the cost of manufacturing solar cells. Thereby, high light conversion efficiencies have to be provided at reduced costs.

Further, the existing efficiency of a PV module has to be stable over the lifetime of the module in order to allow for high acceptance of the modules by the consumer. In order to achieve high efficiencies, low manufacturing costs, and long time stability of the final PV module, covering layers and intermediate layers for passivation, high efficiencies, i.e., desired optical properties, and desired properties for the manufacturing process are used.

Besides improvements in the area of the p-n junction, improvements of the covering and intermediate layers are also desired to achieve the desired costs per watt with desired efficiency and long term stability.

### SUMMARY OF THE INVENTION

In light of the above, a solar cell layer stack according to independent claim 1, a method of manufacturing a solar cell layer stack according to independent claim 10, and a system for depositing solar cell layer stack according to independent claim 15 are provided.

According to one embodiment, a solar cell layer stack is provided. The solar cell layer stack includes a doped silicon wafer substrate, a further layer of the substrate or deposited on the substrate, wherein the further layer is doped for generation of a p-n-junction with the doped silicon wafer substrate, a first sputtered passivation layer deposited on the doped silicon wafer substrate or the further layer, wherein the passivation layer is selected from the group consisting of: an aluminum-containing oxide layer, an aluminum-containing oxynitride layer, and mixtures thereof; and wherein the layer stack has at least one characteristic selected from the group of: the passivation layer being plasma treated under a hydrogen-containing atmosphere, the layer stack further includes a hydrogen-containing cap layer on the passivation layer, and combinations thereof.

According to a further embodiment, a method of manufacturing a solar cell layer stack is provided. The method includes providing a doped silicon wafer substrate; doping a further layer of the substrate or depositing a further layer on the substrate, wherein the further layer is doped for generation of a p-n-junction with the doped silicon wafer substrate; reactive sputtering a first passivation layer on the doped silicon wafer substrate or on the further layer. Thereby, the reactive sputtering includes flowing an unreactive gas and an oxygen-containing gas, or an unreactive gas and an oxygen-containing gas and a nitrogen-containing gas in the processing region for depositing the passivation layer. The method further includes a process selected from the group of: plasma treating the first passivation layer under a hydrogen-containing atmosphere; depositing a hydrogen-containing cap layer on the first passivation layer; and combinations thereof.

According to a yet further embodiment, a system for depositing a solar cell layer stack is provided. The system includes three or more chambers adapted for depositing at least a first passivation layer under vacuum atmosphere on a doped silicon wafer substrate and adapted for a hydrogen containing process selected from the group of: hydrogen plasma treatment of the first passivation layer, deposition of a hydrogen-containing layer on the first passivation layer, and combinations thereof; at least one sputter cathode for depositing at least a first sputtered passivation layer in a first process region, wherein the passivation layer is selected from the group consisting of: an aluminum-containing oxide layer, an aluminum-containing oxynitride layer, and mixtures thereof; at least a further electrode in a second process region adapted for at least one process from the group consisting of: hydrogen plasma treatment of the first passivation layer, deposition of a hydrogen containing layer on the first passivation layer in a second deposition region; and mixtures thereof; wherein the first process region and the second process region are in vacuum communication with each other such that the substrate is maintained under vacuum atmosphere while being transferred from the first deposition region to the second deposition region; and wherein the first process region and the second process region are separated by a gas separation chamber.

### BRIEF DESCRIPTION OF THE DRAWINGS

So that the manner in which the above recited features of the present invention can be understood in detail, a more particular description of the invention, briefly summarized above, may be had by reference to the embodiments. The accompanying drawings relate to embodiments of the invention and are described in the following:

Figure 1 shows a schematic view of a layer stack for a solar cell or solar cell module, respectively, according to embodiments described herein;

Figure 2 shows a schematic view of a further layer stack for a solar cell or a solar cell module, respectively according to further embodiments described herein;

Figure 3 shows a system for depositing a layer stack according to embodiments described herein; and

Figure 4 shows a flow chart illustrating a method of manufacturing a layer stack according to embodiments described herein.

### DETAILED DESCRIPTION OF THE EMBODIMENTS

Reference will now be made in detail to the various embodiments of the invention, one or more examples of which are illustrated in the figures. Within the following description of the drawings, the same reference numbers refer to same components. Generally, only the differences with respect to individual embodiments are described. Each example is provided by way of explanation of the invention and is not meant as a limitation of the invention. For example, features illustrated or described as part of one embodiment can be used on or in conjunction with other embodiments to yield yet a further embodiment. It is intended that the present invention includes such modifications and variations.

Embodiments described herein refer to layer stacks for solar cells or solar modules which are based on silicon wafers. Thereby, a passivation layer is sputtered. According to typical embodiments described herein, a reactive sputtering process is used for sputtering the layer stack of the solar cell. According to yet further embodiments, which can be combined with other embodiments described herein, the middle frequency sputtering having frequencies in the range of 5 kHz to 100 kHz, for example, 30 kHz to 50 kHz, can be provided for manufacturing the solar cell layer stack. According to yet even further embodiments, typically n-doped or p-doped wafers can be used. However, especially for high efficiency solar cell modules, n-doped wafers, i.e., p-type wafers, can be used for embodiments described herein. Thereby, the doping of adjacent layers might be more easily conducted.

The sputtering, for example the reactive sputtering, described for embodiments of passivation layers generally refers to sputtering of aluminum oxide, aluminum nitride, or aluminum oxynitride (AlO_{X}N_{Y}.) Such layers have been found to be especially useful for passivation of crystalline solar cells. Thereby, for example, the middle frequency process in the frequency range described above can be used to deposit a dielectric layer that contains aluminum.

Typically, according to some embodiments, which can be combined with other embodiments described herein, the use of p-type silicon wafers results in a long term stability of the cell efficiency of a solar cell. However, the use of sputtered silicon oxide for passivation of, for example p-type silicon wafers, has not shown the desired properties.

Accordingly, an alternative passivation layer for wafer-based solar cells is desired. The inventors of the present invention found that reactively-sputtered, aluminum-containing oxide layers, or reactively-sputtered, aluminum-containing oxynitride layers according to embodiments described herein and/or manufactured according to embodiments described herein can improve the passivation of the doped wafer substrate and, thereby, the solar cell efficiency and the long-term stability of the solar cell efficiency. Further, the lifetime of carriers, particularly the minority carriers, in the active region of the solar cell layer stack is one aspect that needs to be considered for improvement of the efficiency.

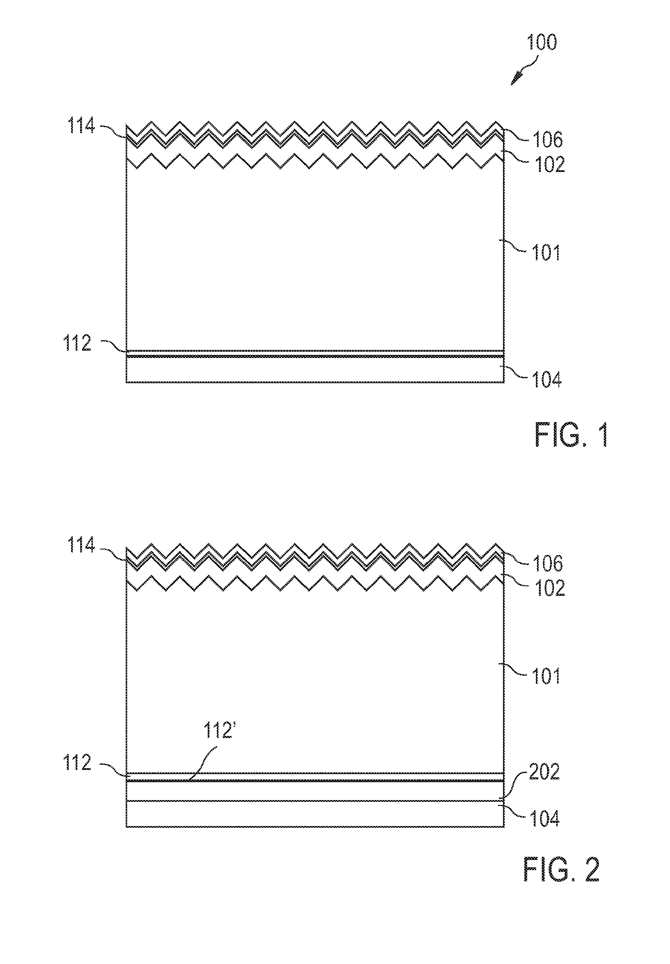

As shown in figure 1, a doped silicon wafer substrate 101 can be used for depositing the individual layers on the substrate for forming the layer stack of a solar cell. Thereby, a p-type wafer or an n-type wafer can be used. However, typically, an n-doped silicon wafer, i.e., a p-type wafer, might be used because the use of doping elements during manufacturing is more easily realized. However, according to another typical aspect, a p-doped silicon wafer, i.e., an n-type wafer, might be used as a promising candidate for long term stability of high cell efficiencies.

In Fig. 1, on the one hand, a further doped silicon layer 102 is shown to be a portion of the substrate or to be deposited on the substrate 101. Thereby, the doped silicon layer has a doping to generate at p-n-junction for generation of the solar cell. Accordingly, if an n-type wafer 101 is used, a p-type layer 102 is used. If a p-type wafer 101 is used, an n-type layer 102 is used to form the p-n-junction. The further layer can be manufactured by additional doping of the layer 102 being a portion of the doped substrate or by depositing the layer 102 on the substrate; or by mixtures thereof.

As shown in figure 1, the layers stack 100 further includes a passivation layer 114 deposited on the doped silicon layer 102 and an anti-reflection coating 106.

In Fig. 1, on the other hand, on the backside of the substrate 101, a back contact 104, which is typically made of aluminum, is provided. Between the wafer 101 and the back contact 104, a passivation layer 112 is deposited. As will be understood by a person skilled in the art, the passivation layer 112 is typically deposited on the doped silicon wafer substrate 101 before the back contact 104 is provided.

As described above, figure 1 shows a layer stack having at least the first passivation layer on the back side of the layer stack. For easier understanding, through-contacts from the back contact 104 to the substrate 101 and contacts on the front surface of the layers stack are omitted. Generally, in the illustration shown in figure 1, the top side of the layer stack 100 will be referred to as the front surface of the layer stack, i.e., the surface through which photons enter the solar cell, and the bottom portion of the layers in Fig. 1 will be referred to as the back surface of the solar cell.

According to embodiments described herein, one or both of the passivation layers 112 and 114, typically at least the passivation layer 112 at the backside of the layers stack 100, is a sputtered aluminum oxide layer, a sputtered aluminum nitrite layer, or a sputtered aluminum oxynitride layer. The sputtering can be conducted as a reactive sputtering, wherein argon is used as an un-reactive gas and oxygen and/or nitrogen are used as reactive gases. According to some embodiments, which can be combined with other embodiments described herein, hydrogen is not used as a process gas for reactive sputtering of the Al₂O₃ layer. According to some embodiments, the aluminum-containing passivation layer according to embodiments described herein, can at least be provided on the p-doped side of the two layers 101 and 102, that is the doped substrate (101) and the further doped layer (102). The layer 102 can also be referred to as the emitter.

Often Atomic Layer Deposition (ALD) is used to deposit high quality aluminum oxide films, e.g., Al₂O₃, to passivate surfaces of p- and/or n-type. Further, processes using PECVD have been employed. However, it should be noted that a sputtered Al₂O₃ layer is different from Al₂O₃ layers deposited by other deposition methods such as ALD, SACVD, CVD, or PECVD. Whether or not an Al₂O₃ layer is sputtered can be determined by the plurality of evaluation methods such as SEM, TEM, or the like. Providing the desired layer properties for the aluminum-containing dielectric passivation layers described herein is not derivable or obvious over corresponding layers provided by a different deposition method. Further, the desire to reduce the costs per watt for solar cell modules requires a deposition rate of, for example, 5 nm/min to 50 nm/min. Accordingly, for embodiments of manufacturing a layer stack for a solar cell as described herein, a deposition rate of at least 5 nm/min, typically of 5 nm/min to 40 or even 50 nm/min, is provided. According to some embodiments, which can be combined with other embodiments described herein, PVD-based aluminum oxide deposition has been developed as an cost competitive deposition approach with high uniformity. Thereby, for an, e.g., 20 nm Al₂O₃ film, carrier life time improvement can be realized after the post deposition annealing step (carrier life time prior annealing < 5µsec, carrier life time after annealing: ∼100µsec).

According to different embodiments, which can be combined with other embodiments described herein, the Al₂O₃ layer can be an aluminum oxide (Al₂O₃) layer, Al₂Ox (x being in the range of, e.g., 2.5 to 3 or 2.8 to 3), such as an Al₂O_{2.9} layer, or an aluminum oxide layer with at least 40 atomic % of oxygen or at least 55 atomic-% of oxygen. In the event the layer is not an Al₂O₃ layer, i.e., the deposited aluminum layer is not fully oxidized, the remaining material occurs, for example, as aluminum or another appropriate material. According to yet further embodiments, the passivation layer can be an Al₂O_{X} layer wherein X is from about 2.8 to 3 or the passivation layer can be an AlO_{X}N_{Y} layer wherein X is from about 2.7 or to 2.9.

According to yet further embodiments, also the optical properties such as the refractive index of the passivation layer need to be considered for providing a high efficiency solar cell, as the solar cell is also an optical device. Typically, the Al₂O₃ layer can have a refractive index of 1.5 to 2.1 such as, for example, 1.6, 1.65, or 1.9. Thereby, if X is reduced in Al₂O_{X}, the refraction index is increased. Generally, if reference is made to values of a refractive index herein, the values are measured according to typical experimental setups, e.g., at a wavelength of 589 nm and under one of the accepted standard conditions for temperature and pressure.

Accordingly, the sputtering of the passivation layer can be used to adjust the refractive index of the layer by adding materials like nitrogen or by not fully oxidizing the layer.

According to some embodiments of manufacturing a solar stack, argon, oxygen, and nitrogen are introduced in the processing region of the sputtering process. Thereby, variation of those gases influences the composition of the passivation layer. The gases also influence the deposition rate of the Al₂O₃ layer during the process. For example, nitrogen can be provided at a flow rate of 0.5 to 1.1 times the flow rate of oxygen, wherein none or only a minority of the nitrogen is incorporated in the layer but serves for process improvements such as process stability, deposition rate, or the like. According to yet further embodiments, which can be combined with other embodiments described herein, the deposition of the passivation layer can be conducted at low power and/or low pressures. Typically, the power density can be in the range of 1 W/cm² to 10 W/cm² and/or the pressure can be in the range of 1*10⁻³ mbar to 9*10⁻³ mbar, for example, 1.5*10⁻³ mbar to 8*10⁻³ mbar. Thereby, also the power and the pressure can be used to influence the deposition rate and the refraction index of the deposited aluminum oxynitride layer.

According to the embodiments described herein, an improvement of carrier life time is achieved when the one or more PVD-based, aluminum-containing oxide layer, aluminum-containing oxynitride layer, and mixtures thereof is capped with a hydrogen-containing cap layer, such as SiNₓ:H, and/or by an hydrogen-containing plasma pre-treatment prior to deposition of SiNₓ or SiNₓ:H. The hydrogen-containing cap layer can be deposited and/or the hydrogen-containing plasma treatment can either be with vacuum break (between passivation layer deposition and SiNₓ:H deposition) or without vacuum break (insitu).

Fig. 1 shows the passivation layer 112 and the bottom portion thereof is indicated with a thick line 112' indicating changes to the layer properties on treatment with a hydrogen containing plasma. For example, a plasma having NH₃ as a processing gas can be used for hydrogen-containing plasma treatment.

According to some embodiments, which can be combined with other embodiments described herein, the aluminum-containing oxide passivation layer is deposited by reactive PVD. Thereby, Al-cathodes, typically Al rotatable cathodes, and oxygen are used. According to different alternatives, aluminium oxide processes below and above the transition region, in the oxide mode and the transient mode can be applied.

Typically, an Al₂O₃ layer, for example, with a thickness having a range of 15 nm to 40 nm, such as 20 nm, can be capped with a SiNₓ:H layer, for example with a thickness having a range of 50 nm to 100 nm, such as 75 nm. Additionally, a NH₃ plasma treatment can be provided prior the SiNₓ:H deposition. Thereby, the surface passivation can be further enhanced.

According to yet further embodiments, which can be combined with other embodiments described herein, the aluminum-containing oxide layer is deposited in the oxide mode. Thus, Al₂O_{X} with X being 3 or being close to 3, such has 2.8 to 3 is used for the one or more passivation layers. Thereby, a lifetime of the minority carrier of up to about 600 µs can be realized for relatively thin aluminum-containing oxide passivation layers in a range of 15 nm to 30 nm. Providing relatively thin passivation layers has the advantage of reducing the processing time in light of the relatively low deposition rate of Al₂O₃.

According to the embodiments described herein, after the deposition step of SiNₓ or SiNₓ:H, an annealing step is conducted. Thereby, for example, air or nitrogen might be used to generate the environment during an annealing and temperatures ranging from 300°C to 1200°C can be used. According to typical embodiments, which can be combined with other embodiments described herein, the temperature influences the process time. Both temperature and time may depend on the thickness of the Al₂O₃ layer. According to typical embodiments, annealing can take place from about 30 sec to about 30 min, typically from 2 min to 15 min or, typically, from 3 min to 8 min.

As shown in figure 1, the front surface of the wafer substrate 101 has a structured or textured surface. This allows for better light conversion efficiency because more photons enter the active area of the solar cell layer stack. According to some embodiments, which can be combined with other embodiments described herein, the thicknesses of the passivation layer 112 and/or 114, respectively, can be in a range of 10 nm to 100 nm, typically in a range of 20 nm to 80 nm.

As described above, typically the passivation layer on the back side of the solar cell layer stack, i.e., the passivation layer 112, which is an AlO_{X}N_{Y} layers according to embodiments described herein, is provided for improvement of the cell efficiency and, particularly, the long-term cell efficiency of a solar cell module. According to yet further embodiments, which can be combined with other embodiments described herein, the passivation layer 114, the passivation layer 112 or both passivation layers 112 and 114 can be provided as a AlO_{X}N_{Y} layer as described herein. Thereby, the aluminum-containing dielectric passivation layers can be particularly desirable for high-quality, wafer-based solar cells. Solar cells which are based on lower quality silicon wafers might benefit from hydrogen that can diffuse through passivation layers, particularly from the anti-reflection coating 106. Particularly if high quality doped silicon wafer substrates are used, this diffusion of hydrogen might not be required or can even be disadvantageous. Accordingly, the AlO_{X}N_{Y} passivation layers according to embodiments described herein can be optimized with respect to other parameters, such as long-term stability and optical behavior, because diffusion aspects do not need to be taken into account. A further advantage of the AlO_{X}N_{Y} passivation layers can be the high temperature stability and its inertness with respect to aluminum allowing a high deposition rate aluminum evaporation in a subsequent layer, e.g., a back contact layer 104 shown on Figs 1 and 2. A yet further advantage of AlO_{X}N_{Y} passivation layers due to the high thermal stability can be that the AlO_{X}N_{Y} passivation layers can serve as a mask for selective front-side texturing.

According to some embodiments of manufacturing a solar cell layer stack, the reactive sputtering can be conducted while the substrate is at substantially room temperature, i.e., the substrate is not additionally heated by heating sources but merely increases its temperature by the energy provided due to the deposition process. For example, the substrate might have a temperature of 70°C or below, e.g., 20°C to 50°C. Thereby, according to specific implementations, which can be combined with other embodiments described herein, hydrogen is not used as a processing gas for the reactive sputtering of the AlO_{X}N_{Y} layer. Even though on first sight hydrogen might be considered as providing an improvement to the properties of the passivation layer, such an improvement might show the reverse effect, i.e., a lower quality with respect to the desired characteristics, after annealing of the passivation layer. According to yet further embodiments, which can be combined with other embodiments described herein, the aluminum-containing oxide layer may also be sputtered at high temperatures such as substrate temperatures of 400 °C or less, such as 150 °C to 300 °C.

Further embodiments of layer stacks for solar cells or solar cell modules, respectively, will now be described with respect to figure 2. Thereby, in addition to the above described embodiments, the passivation properties can be further improved by depositing another dielectric layer, for example, silicon nitride, on the AlO_{X}N_{Y} layer. According to embodiments described herein, the further dielectric layer is a hydrogen-containing layer. Thereby, a hydrogen-containing cap layer for the aluminum containing oxide passivation layer is provided.

As shown in Figure 2, the further dielectric layer 202, such as a silicon nitride layer (SiNₓ:H), is provided between the doped silicon wafer substrate 101 and the back contact 104. Besides further improvement of the passivation, this might also yield better optical properties. Depending on the thickness and composition of such a layer, for example, silicon nitride can be used as the reflective layer such that photons entering the layer stack from the front surface and passing through the solar cell layer stack without generating an electron-hole-pair in the active region of the solar cell are reflected back into the active region. The probability of generation of an electron-hole pair is thereby increased.

According to optional modifications, the cap layer, e.g., a SiNₓ:H layer, on the back side of the layer stack can have a refractive index n of 2.0 to 2.4. For embodiments, wherein a cap layer is provided on the front side of the layer stack, the refractive index of the cap layer, e..g., a SiNₓ:H layer, can be about 1.9 to about 2.1.

According to yet further embodiments, which can be combined with other embodiments described herein, the passivation layer can have a passivation assist layer, such as, for example, aluminum nitride, silicon nitride, or another dielectric layer. As described below, the deposition rate of aluminum oxide might be comparably low. Thus, it might be beneficial for improvement of throughput if the aluminum-containing oxide layer or the aluminum-containing oxynitride layer is grown as thin as possible and is further assisted by a passivation assist layer such as AIN, SiNₓ, or the like. Accordingly, as one example, the layer stack shown in Fig. 2 might have a further AIN layer between the layer 112 and the layer 202.

According to yet further embodiments, the further dielectric layer on top of the other passivation layer 114 (not shown in figure 2) might also improve the passivation layer properties. Thereby, however, the optical properties need to be optimized for having photons transmitted into the solar cell layer stack and not for reflecting photons as described with respect to the back side above.

Typically, the aluminum containing oxide layer or the aluminum containing oxynitride layer can be used for passivation of e.g., the n-doped silicon wafer substrate. Thereby, a passivation of the doped layer occurs also in light of the charge of the respective layer. Even though an Al-containing passivation layer 114 similar to the backside passivation layer might not be straight forward, as, generally, the doping of layer 102 is different from the doping of the substrate 101, there might be more complex or more sophisticated silicon layer stacks with respective doping profiles that the aluminum-containing oxide layer or the aluminum-containing oxynitride layer can be used at a back side and at a front side of the layer stack.

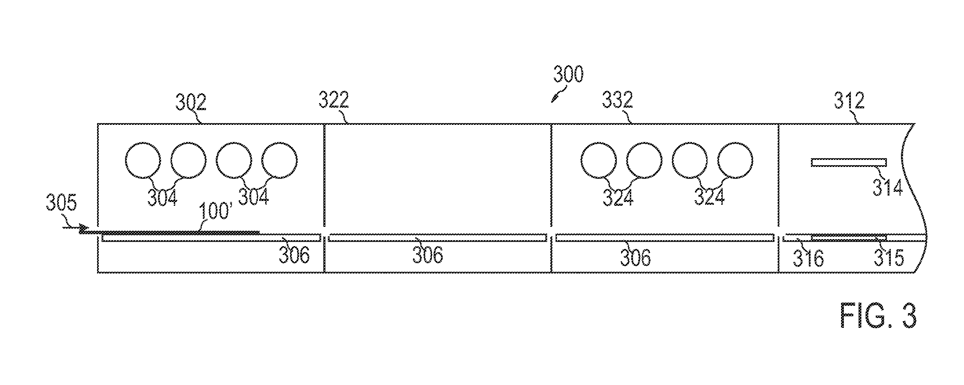

Figure 3 illustrates a system 300 that can be used for manufacturing an AlO_{X}N_{Y} passivation layer with a hydrogen-containing atmosphere plasma treatment and/or a hydrogen-containing cap layer according to embodiments described herein. The system 300 includes three or more chambers. Figure 3 illustrates the first chamber 302, the second chamber 322, a third chamber 332, and a further chamber 312. The substrate 100' or a plurality of substrates, which can, for example, be provided on a carrier, enters the first chamber 302 through a slit in the chamber wall. For example, the substrate might be inserted from the preceding chamber (not shown), a load lock chamber or the like. Thereby, the arrangement of chambers allows for low-pressure process in the chamber 302. Within the chamber 302, the substrate is guided on a substrate support 306.

In the case of an in-line process, the substrate moves continuously along direction 305 while deposition of the passivation layer is conducted. Alternatively, a stationary deposition process can be provided when the substrate is first moved into the chamber 302 and deposition starts after the substrate has been positioned in the deposition region.

The example shown in figure 3 includes four rotatable sputtering cathodes 304, which provide the material to be sputtered, i.e., aluminum, to the processing region. According to yet further embodiments, which can be combined with other embodiments described herein, two or more cathodes can be provided, wherein those cathodes can be planar cathodes or rotatable cathodes. However, rotatable cathodes can result in reduced manufacturing costs and thus, an improved cost per watt of the solar cell. Typically, magnetron sputtering is conducted. As described above, reactive sputtering can be provided by flowing reactive gases like oxygen, oxygen-containing gases, nitrogen, nitrogen containing gases, carbon-containing gases, and/or mixtures thereof, and un-reactive gases like argon, xenon or the like (typically argon) in the processing region. Thereby, the sputtered aluminum reacts with the reactive gases and forms the desired aluminum oxide layer, aluminum nitride layer or aluminum oxynitride layer.

After the passivation layer has been deposited by a reactive sputtering process on the silicon substrate wafer or the additional silicon film (see layers 101 and 102, respectively in figures 1 and 2) the substrate is transferred to the second chamber 322. Therein, the substrate support 316 is provided. The second chamber 322 acts as a gas separation chamber between the oxygen containing process in the first chamber and the one or more hydrogen containing processes in the third chamber 332. Thereby transfer of oxygen in the third chamber and transfer of hydrogen in the first chamber can be avoided. According to some embodiments, which can be combined with other embodiments described herein, the gas separation chamber is separated from the first chamber 302 and the third chamber 332 by valves (not shown) such that one valve can be closed at essentially all times.

The substrate 100' is transferred through the gas separation chamber in the third chamber 332. Within the third chamber, cathodes 324 are provided. The cathodes can be used for plasma treatment of the aluminum-containing oxide passivation layer. Thereby, for example NH₃ is inserted in the chamber in order provide a hydrogen-containing plasma. Additionally or alternatively, the third chamber 332 can be used for deposition of the hydrogen-containing dielectric cap layer. If, for example, SiNₓ:H is used as a hydrogen-containing cap layer silicon sputter cathodes, for example, rotatable sputter cathodes, can be provided in the chamber 332. The silicon nitride film can be deposited by reactive sputtering with nitrogen or another nitrogen containing gas. For hydrogen implantation in the cap layer, a hydrogen containing gas such as NH₃ can be used.

After deposition of the cap layer or after the plasma treatment, an annealing process is conducted in the further chamber 312. Similar as in the other chambers, a substrate stage 316 is provided. Further, heating units 314 and 315 are provided in the chamber in order to conduct the annealing process. According to different embodiments, heating units 314 opposing the deposited surface can be provided in the chamber 312. According to alternative or additional modifications thereof, heating units 315 below the silicon wafer substrate can be provided. The latter can be provided below or within the substrate support for heating the wafer from the side opposing the deposited layer.

Examples of a heating units and substrate supports are described in a co-pending application filed by the applicant and entitled "SUBSTRATE TRANSPORT SYSTEM AND METHOD", which is incorporated herein by reference to the extent that the applications are not inconsistent with this disclosure.

Depending on the annealing time, the annealing can be conducted in-situ, i.e., inline with the other processes, that is within a chamber 312 integrated in a process line as shown in Fig. 3. However, according to yet further alternative embodiments, particularly if longer annealing times are provided, an annealing chamber can be provided, which is separate from the processing system 300. Thereby, the other processes are time-wise not restricted by a relatively long annealing process.

As shown in Fig. 3, a system includes at least a deposition chamber for an AlO_{X}N_{Y} passivation layer, a gas separation chamber, a hydrogen process chamber, and an optional annealing chamber. However, according to yet further embodiments, further chambers can be provided in the system to deposit two or more of the layers in the layer stacks according to embodiments described herein, and as exemplarily shown in Figs. 1 and 2. Thereby, according to some embodiments, which can be combined with other embodiments described herein, a further chamber (not shown in Fig. 3) can be provided which is in vacuum-sealed communication with respect to the first chamber 302 such that a first passivation layer and a second passivation layer can be deposited without the substrate 100' leaving the vacuum. Thereby, at least one of the passivation layers is a sputtered AlO_{X}N_{Y} passivation layer and a hydrogen plasma treatment and/or a hydrogen containing cap layer deposition is provided after sputter deposition of the AlO_{X}N_{Y} passivation layer, see, e.g., chamber 332 in Fig. 3. Typically, according to some embodiments, the annealing is conducted in an rapid thermal anneal chamber or the annealing can be conducted in an integrated in-situ rapid thermal anneal station post the AlO_{X}N_{Y} deposition, for example, in the deposition chamber for depositing the passivation layer itself.

As described above, the system is adapted for depositing the layers of the layer stack or at least the one or more passivation layers and hydrogen-containing cap layer of the layer stack without breaking the vacuum for the substrate. Thereby, adjacent chambers can be vacuum sealed with respect to each other, intermediate chambers, such as gas separation chamber 322, for transfer of the substrate from a passivation deposition chamber to a hydrogen cap layer deposition (and/or hydrogen plasma treatment) chamber can be provided, wherein the intermediate chamber are adapted for transferring the substrate under vacuum conditions.

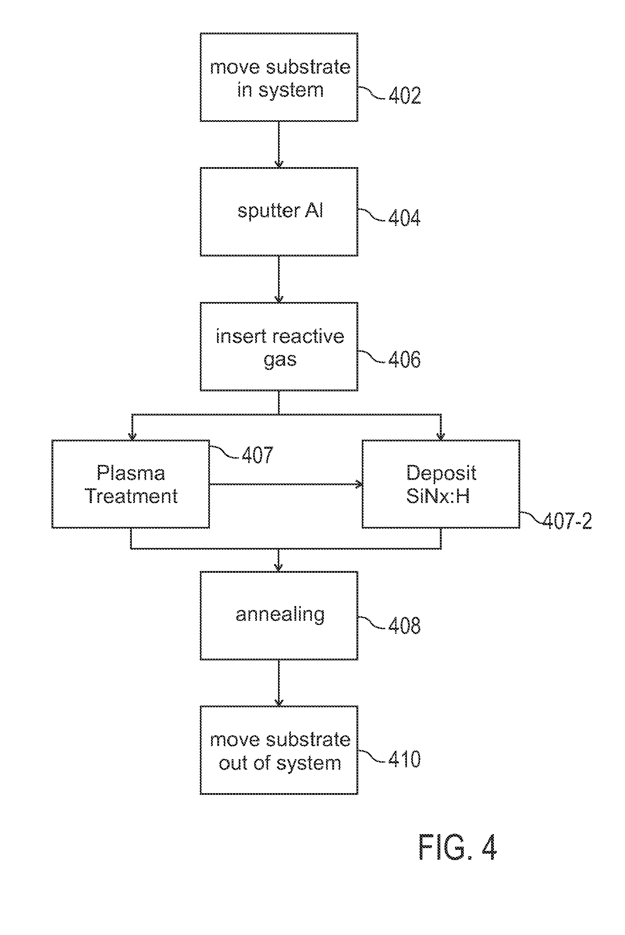

Figure 4 illustrates yet further embodiments of methods of manufacturing a solar cell layer stack. In step 402, a substrate, for example, a doped wafer substrate, is inserted in a processing system for manufacturing the layer stack. In step 404, aluminum is sputtered to deposit an aluminum-containing dielectric layer, wherein in step 406 a reactive gas such as oxygen and, optionally, nitrogen as a further reactive gas, is inserted in the deposition region of the sputtering system. As already described above, according to yet further embodiments, which can be combined with other embodiments described herein, also un-reactive gases like argon can be inserted in the chamber, that is the processing region for the reactive sputtering.

Embodiments of aluminum-containing oxide layers or aluminum-containing oxynitride layers as described herein can provide an improvement for the efficiency of the solar cell or a solar cell module respectively. Thereby, it is typically understood that an aluminum-containing oxide layer or aluminum-containing oxynitride layer should be an aluminum-based layer. For example, the aluminum content should be at least 10 atomic %, at least 20 atomic % or even at least 30%.

Thereafter, a plasma treatment with a hydrogen-containing atmosphere can be conducted in step 407. Thereby, the aluminum-containing passivation layer is provided with the hydrogen plasma treatment. Additionally or alternatively (both options are shown in FIG. 4), a hydrogen-containing cap layer, for example, SiNₓ:H can be deposited on the aluminum-containing passivation layer.

Examples, wherein Al₂O₃ is reactively sputtered and a hydrogen plasma treatment and/or hydrogen cap layer deposition is provided thereafter show an improvement of the lifetime of electron-hole-pairs in the sample. The lifetime in Al₂O₃ after hydrogen treatment and hydrogen-containing cap layer deposition and after annealing was above 500 µs for an, e.g., 20 nm thick Al₂O₃ layer. These results are examples given at a 5 min annealing at 550 °C under air atmosphere.

According to some embodiments, hydrogen is not flowed into the processing region during the reactive sputtering process of the aluminum containing oxide layer. In step 408, the sputtered aluminum-containing dielectric passivation layer, which has been plasma treated and/or on which a hydrogen-containing cap layer has been deposited, is annealed in step 408 under conditions, which are, for example, described herein above. In step 410, the substrate is moved out of the system. As will be understood by a person skilled in the art, further deposition steps or processing steps of the layer stack for solar cell or solar cell module, respectively, can be conducted before the substrate is moved out of the processing system. According to yet further embodiments, similar steps as described with respect to step 404, 406, 407, and 408, can be provided for a second aluminum-containing passivation layer such that a formula passivation layer is also provided on an opposing side of the substrate.

Embodiments described herein allow for improved carrier lifetime and, thus, improved efficiencies of solar cells. The solar cell layer stacks which are provided according to embodiments described herein and which result of methods of manufacturing the solar cell layer stacks thereby include an aluminum-containing oxide layer, an aluminum-containing oxynitride layer, or mixtures thereof. Further, a plasma treatment with a hydrogen-containing plasma and/or a hydrogen-containing cap layer are provided for the passivation layer. According to some embodiments, which can be combined with other embodiments described herein, the passivation layer or the passivation layers are deposited on oxide mode; the deposition of the passivation layer was conducted without additional heating of the substrate (at room-temperature, i.e., 20°C to 70°C); and/or an annealing step after plasma treatment and, if applicable, after the hydrogen cap layer deposition is provided.

In light of the above a plurality of embodiments has been described. For example, a solar cell layer stack is provided, wherein the layer stack includes a doped silicon wafer substrate, a further layer of the substrate or deposited on the substrate, wherein the further layer is doped for generation of a p-n-junction with the doped silicon wafer substrate, a first sputtered passivation layer deposited on the doped silicon wafer substrate or the further layer, wherein the passivation layer is selected from the group consisting of: an aluminum-containing oxide layer, an aluminum-containing oxynitride layer, and mixtures thereof; and wherein the layer stack has at least one characteristic selected from the group of: the passivation layer being plasma-treated under a hydrogen-containing atmosphere, the layer stack further includes a hydrogen-containing cap layer on the passivation layer, and combinations thereof. According to yet further embodiments, which can be combined with other embodiments described herein, the first passivation layer can be selected from the group consisting of: the first passivation layer includes mainly Al₂O_{X} wherein X is in the range of 2.7 to 3, the first passivation layer having an average oxygen content of 50% atomic oxygen or more in the form of aluminum oxide, and the first passivation layer includes mainly Al₂O_{X}N_{Y} layer and wherein X is in the range of 2.5 to 2.9. Thereby, typically, as a yet further alternative or additional modification, the first passivation layer can have a refractive index of 1.55 to 2.1. According to another implementation, which can be combined with embodiments described herein, a further sputtered passivation layer on the side of the wafer substrate opposing the first sputtered passivation layer can be provided, wherein the further passivation layer is selected from the group consisting of: an aluminum containing oxide layer, an aluminum containing oxynitride layer, and mixtures thereof, and wherein the further passivation layer being plasma treated under a hydrogen-containing atmosphere and/or wherein the layer stack further includes a hydrogen-containing cap layer on the further passivation layer. Thereby, typically, as a yet further optional modification, the further passivation layer can be selected from the group consisting of: the further passivation layer including mainly Al₂O_{X} wherein X is in the range of 2.7 to 3, the further passivation layer having an average oxygen content of 50% atomic oxygen or more in the form of aluminum oxide, and the further passivation layer including mainly Al₂O_{X}N_{Y} layer and wherein X is in the range of 2.5 to 2.9. Thereby, the above recited passivation layers and/or the hydrogen containing cap layers can be annealed layers. According to a yet further embodiment, which can be combined with other embodiments described herein, the hydrogen containing cap layer can be is a SiN_{X}:H layer, and particularly a reflection layer deposited between the substrate and a back contact layer. As a further additional or alternative modification of the above described embodiments, the substrate can be an n-doped silicon wafer; and or the thickness of the passivation layers can about 50 nm or less, preferably the thickness can be in the range of 10 nm to 30 nm.

According to yet further embodiments, a method of manufacturing a solar cell layer stack having a back contact layer, is provided. The method includes: providing a doped silicon wafer substrate, doping a further layer of the substrate or depositing a further layer on the substrate, wherein the further layer is doped for generation of a p-n-junction with the doped silicon wafer substrate, reactive sputtering a first passivation layer on the doped silicon wafer substrate or on the further layer. Thereby, the reactive sputtering includes flowing an unreactive gas and an oxygen-containing gas, or an unreactive gas and an oxygen-containing gas and a nitrogen-containing gas in the processing region for depositing the passivation layer. The method further includes a process selected from the group of: plasma treating the first passivation layer under a hydrogen-containing atmosphere, depositing a hydrogen-containing cap layer on the first passivation layer; and combinations thereof. According to yet further embodiments, which can be combined with other embodiments described herein, the method can further include reactive sputtering a further passivation layer on the substrate or on the further layer and on the side of the substrate opposing the first passivation layer. The reactive sputtering of the further passivation layer includes: flowing an unreactive gas and an oxygen-containing gas, or an unreactive gas and an oxygen-containing gas and a nitrogen-containing gas in the processing region. The method can further include plasma treating the further passivation layer under a hydrogen-containing atmosphere and/or depositing a hydrogen-containing cap layer on the further passivation layer. According to yet further alternative or additional modifications the reactive sputtering of the first passivation layer and/or the reactive sputtering of the further passivation layer can include flowing an argon-containing gas and an oxygen-containing gas and a nitrogen-containing gas in the processing region such that the passivation layer and/or the further passivation layer includes mainly AlO_{X}N_{Y},, wherein X is in the range of 2.5 to 3. Yet further embodiments, which can be combined with other embodiments described herein, can further include annealing the passivation layers and/or the hydrogen-containing cap layers. Thereby, according to a typical optional modification, the annealing of the passivation layers and/or the annealing of the cap layers can be conducted at a temperature T in the range of 300°C to 1200°C and a time t in the range of 30 seconds to 30 min.

According to yet further embodiments, a system for depositing a solar cell layer stack, preferably a layer stack according to embodiments described herein, is provided. The system includes three or more chambers adapted for depositing at least a first passivation layer under vacuum atmosphere on a doped silicon wafer substrate and adapted for a hydrogen-containing process selected from the group of: hydrogen plasma treatment of the first passivation layer, deposition of a hydrogen-containing layer on the first passivation layer, and combinations thereof; at least one sputter cathode for depositing at least a first sputtered passivation layer in a first process region, wherein the passivation layer is selected from the group consisting of: an aluminum-containing oxide layer, an aluminum-containing oxynitride layer, and mixtures thereof, at least a further electrode in a second process region adapted for at least one process from the group consisting of: hydrogen plasma treatment of the first passivation layer, deposition of a hydrogen-containing layer on the first passivation layer in a second deposition region; and mixtures thereof; wherein the first process region and the second process region are in vacuum communication with each other such that the substrate is maintained under vacuum atmosphere while transferred from the first deposition region to the second deposition; and wherein the first process region and the second process region are separated by a gas separation chamber. According to yet further embodiments, which can be combined with other embodiments described herein, the system can further include an anneal station, in particular, a rapid thermal anneal station provided in an anneal chamber or integrated for in-situ annealing after deposition.

While the foregoing is directed to embodiments of the invention, other and further embodiments of the invention may be devised without departing from the basic scope thereof, and the scope thereof is determined by the claims that follow.

## Claims

1. A solar cell layer stack comprising:
a doped silicon wafer substrate (101);
a further layer (102) of the substrate or deposited on the substrate, wherein the further layer is doped for generation of a p-n-junction with the doped silicon wafer substrate; and
a first sputtered passivation layer (112, 114) deposited on the doped silicon wafer substrate (101) or the further layer (102), wherein the passivation layer is selected from the group consisting of: an aluminum-containing oxide layer, an aluminum-containing oxynitride layer, and mixtures thereof; and
wherein the passivation layer being plasma treated under a hydrogen-containing atmosphere and/or wherein the layer stack further comprises a hydrogen-containing cap layer (202) on the passivation layer.

2. The solar cell layer stack according to claim 1, wherein the first passivation layer is selected from the group consisting of: the first passivation layer comprises mainly Al₂O_{X} wherein X is in the range of 2.7 to 3, the first passivation layer having an average oxygen content of 50% atomic oxygen or more in the form of aluminum oxide, and the first passivation layer comprises mainly Al₂O_{X}N_{Y} layer and wherein X is in the range of 2.5 to 2.9.

3. The solar cell layer stack according to any of claims 1 to 2, wherein the first passivation layer has a refractive index of 1.55 to 2.1.

4. The solar cell layer stack according to any of claims 1 to 3, further comprising:
a further sputtered passivation layer (114; 112) on the side of the wafer substrate opposing the first sputtered passivation layer, wherein the further passivation layer is selected from the group consisting of: an aluminum containing oxide layer, an aluminum containing oxynitride layer, and mixtures thereof; and
wherein the further passivation layer being plasma treated under a hydrogen containing atmosphere and/or wherein the layer stack further comprises a hydrogen containing cap layer on the further passivation layer.

5. The solar cell layer stack according to claim 4, wherein the further passivation layer is selected from the group consisting of: the further passivation layer comprising mainly Al₂O_{X} wherein X is in the range of 2.7 to 3, the further passivation layer having an average oxygen content of 50% atomic oxygen or more in the form of aluminum oxide, and the further passivation layer comprising mainly an Al₂O_{X}N_{Y} layer and wherein X is in the range of 2.5 to 2.9.

6. The solar cell layer stack according to any of claims 1 to 5, wherein the passivation layers and/or the hydrogen-containing cap layers are annealed layers.

7. The solar cell layer stack according to any of claim 1 to 6, wherein the hydrogen-containing cap layer (202) is a SiNx:H layer, and, particularly, a reflection layer deposited between the substrate (101) and a back contact layer (104).

8. The solar cell layer stack according to any of claims 1 to 7, wherein the substrate (101) is an n-doped silicon wafer.

9. The solar cell layer stack according to any of claims 1 to 8, wherein the thickness of the first passivation layer and/or the thickness of the further passivation layer is about 50 nm or less, preferably the thickness is in the range of 10 nm to 30 nm.

10. A method of manufacturing a solar cell layer stack, the method comprising:
providing a doped silicon wafer substrate (101);
doping a further layer of the substrate or depositing a further layer (102) on the substrate, wherein the further layer is doped for generation of a p-n-junction with the doped silicon wafer substrate;
reactive sputtering a first passivation layer (112, 114) on the doped silicon wafer substrate (101) or on the further layer (102), the reactive sputtering comprises:
flowing an unreactive gas and an oxygen-containing gas, or an unreactive gas and an oxygen-containing gas and a nitrogen-containing gas in the processing region for depositing the passivation layer; and
a process selected from the group of: plasma treating the first passivation layer under a hydrogen-containing atmosphere, depositing a hydrogen-containing cap layer on the first passivation layer; and combinations thereof.

11. The method according to claim 10, further comprising:
reactive sputtering a further passivation layer on the substrate or on the further layer and on the side of the substrate opposing the first passivation layer, the reactive sputtering of the further passivation layer comprises:
flowing an unreactive gas and an oxygen-containing gas, or an unreactive gas and an oxygen-containing gas and a nitrogen-containing gas in the processing region; and plasma treating the further passivation layer under a hydrogen-containing atmosphere and/or depositing a hydrogen-containing cap layer on the further passivation layer.

12. The method according to any of claims 10 to 11, further comprising:
annealing the passivation layers and/or the hydrogen-containing cap layers.

13. The method according to claim 12, wherein the annealing of the passivation layers and/or the annealing of the cap layers is conducted at a temperature T in the range of 300°C to 1200°C and a time t in the range of 30 seconds to 30 min.

14. A system for depositing a solar cell layer stack according to any of claims 1 to 9, the system comprising:
three or more chambers adapted for depositing at least a first passivation layer under vacuum atmosphere on a doped silicon wafer substrate (101) and adapted for a hydrogen-containing process selected from the group of: hydrogen plasma treatment of the first passivation layer, deposition of a hydrogen-containing layer on the first passivation layer, and combinations thereof;
at least one sputter cathode for depositing at least a first sputtered passivation layer (112, 114) in a first process region, wherein the passivation layer is selected from the group consisting of: an aluminum-containing oxide layer, an aluminum-containing oxynitride layer, and combinations thereof,
at least a further electrode in a second process region adapted for at least one process from the group consisting of: hydrogen plasma treatment of the first passivation layer, deposition of a hydrogen-containing layer on the first passivation layer in a second deposition region; and mixtures thereof;
wherein the first process region and the second process region are in vacuum communication with each other such that the substrate is maintained under vacuum atmosphere while being transferred from the first deposition region to the second deposition; and
wherein the first process region and the second process region are separated by a gas separation chamber.

15. The system according to claim 14, further comprising an anneal station, in particular, a rapid thermal anneal station provided in an anneal chamber (312) or integrated for in-situ annealing after deposition.
